# EUROPEAN PATENT APPLICATION

(11) **EP 3 761 763 A1**
(43) Date of publication of application: **06.01.2021**
(21) Application number: 19184271.5
(22) Date of filing: 03.07.2019
(51) Int. Cl.: H05K 1/02, H05K 3/30, H05K 3/34

(54) **FILTER WITH BUSBAR ASSEMBLY**

(71) Applicant: Schaffner EMV AG, 4542 Luterbach (CH)
(72) Inventor: Amaducci, Alessandro, 4563 Gerlafingen (CH); Agache, Razvan, 4512 Bellach (CH)
(74) Representative: P&TS SA (AG, Ltd.)

(57) **Abstract**

Method for manufacturing a filter for electromagnetic noise comprising the following steps:
Forming a busbar assembly (6) with a first busbar (1) and a second busbar (2),
mounting on a printed circuit board (5) the busbar assembly (6) formed before, and
mounting at least one electrical component (3.1,3.2,3.21,3.22) on the printed circuit board (5).

## Description

### Field of the invention

The invention relates to a filter for electromagnetic noise comprising a printed circuit board and busbars

### Description of related art

Electric systems in vehicles, e.g. in motor vehicles, are becoming ever more complex. The electrical parts are becoming ever more sensitive to electromagnetic noise and are also causing ever more radio interference. Therefore, filters for suppressing electromagnetic noise, e.g. EMI or EMC filters, are being employed more and more often in electrical systems of vehicles. Particularly in the case of electrically driven vehicles, this problem is particularly relevant on account of the high currents and the high switching speeds of current transformers.

Said filters are generally formed from a combination of one or more conductor rails, one or more inductances and/or one or more capacitors and/or one or more resistors. In this case, in existing solutions, the inductances and capacitors are connected to the conductor rails either directly or via cables. In order to obtain an insulation between the electrical components, either sufficiently large distances or insulations, e.g. by potting the electric components, are provided. However, the existing solutions have the problem that they do not satisfy the combination of requirements in vehicle construction regarding vibrations, simple production in high numbers, high production quality, small space requirement, low weight and flexibility for different power applications.

It was suggested to combine busbar with a printed circuit board (PCB). The busbars are connected to the PCB and the electrical components like capacitors and/or resistors are mounted on the PCB connected to the busbars via conductor tracks of the PCB. However, the electrical connection of the busbars to the PCB is challenging for an industrial manufacturing process. Normally, each busbar is connected by a cable or other connector to the PCB. However, the arrangement of the busbars, the cables and/or connector on the PCB is cumbersome and time-consuming. Therefore, DE102017108383A1 suggested to place the busbars with their flat sides directly on the PCB and fix them with screws and/or soldering. However, this has still several disadvantages. The busbars need still be fixed individually and manually on the PCB. This process cannot be well industrialized. The direct soldering of the busbars requires a high solder temperatures which could damage the PCB.

### Brief summary of the invention

The object of the invention is to find filter and a manufacturing process for such a filter which allows to reliably, easily and quickly connect the busbars to the PCB.

The object is solved by a filter and a method for manufacturing the filter according to the independent claims.

The object is solved by a method for manufacturing a filter for electromagnetic noise comprising the following steps: Forming a busbar assembly with a first busbar and a second busbar; mounting on a PCB the busbar assembly; and mounting at least one electrical component on the PCB.

The object is solved by a filter for electromagnetic noise comprising: a PCB, a busbar assembly with a first busbar and a second busbar, at least one electrical component fixed on the PCB, wherein the busbar assembly forms a single component mounted on the PCB.

By using a busbar assembly with the busbars, only one connection step is needed to connect the busbars in form of the busbar assembly on the PCB. The connection of the busbar assembly can be treated as a standard PCB component so that industrial manufacturing methods can be used. This increases significantly the speed of connecting the busbars to the PCB. In addition, the connection is reliable and easy.

The object is solved by a filter for electromagnetic noise comprising: a PCB, a first busbar and a second busbar (the busbars forming preferably a busbar assembly) and at least one electrical component fixed on the PCB.

The following show further advantageous embodiments of the invention.

In one embodiment, the busbar assembly forms a single component fixed together on the PCB.

In one embodiment, the busbar assembly with the first busbar and the second busbar is formed as a single component, wherein the mounting of the busbar assembly on the printed circuit board comprises the step of soldering the single component to the printed circuit board. Thus, the busbar assembly can be placed and soldered as a standard PCB component on the PCB. The realization of the busbar assembly as a standard PCB component allows industrial manufacturing methods like bulk soldering which are reliable, easy and fast.

In one embodiment, the PCB comprises conductor tracks. The PCB comprises at least a first conductor track connected to the first busbar and/or at least a second conductor track connected to the second busbar.

In one embodiment, the busbar assembly comprises at least one first connector electrically connected to the first busbar, wherein the busbar assembly is mounted to the PCB by electrically connecting the at least one first connector to the PCB, preferably to conductor tracks of the PCB, preferably to the at least one second conductor track of the PCB. In one embodiment, the busbar assembly comprises at least one second connector electrically connected to the second busbar, wherein the busbar assembly is mounted to the PCB by electrically connecting the at least one second connector to the PCB, preferably to conductor tracks of the PCB, preferably to the at least one second conductor track of the PCB.

In one embodiment, the step of forming the busbar assembly comprises the step of mounting the at least one first connector on the first busbar and/or mounting the at least one second connector on the second busbar. In one embodiment, the at least one first connector is a separate component from the first busbar (thus, not integrally formed with the first busbar) and the first connector is fixed to the first busbar, e.g. soldered or welded, and/or the at least one second connector is a separate component from the second busbar (thus, not integrally formed with the second busbar) and the at least one second connector is fixed to the second busbar, e.g. soldered or welded. The at least one first connector and/or the at least one second connector could be extruded directly with the busbar and form an integral part of the busbars. However, those extruded connectors are very rigid and transform all vibrations on the solder-connection of the PCB which can lead to a solder-joint crack and thus a malfunctioning of the filter. In addition, soldering of the rigid extruded connectors require high solder temperatures which can damage the PCB. Therefore, separate connectors can avoid those disadvantages. Preferably, the at least one first connector is formed of a metal blade and/or the at least one second connector is formed of a metal blade.

In one embodiment, the at least one first connector is mounted on the first busbar by soldering or welding and/or the at least one second connector is mounted on the second busbar by soldering or welding.

In one embodiment, the at least one first connector and/or the at least one second connector is/are formed of a metal blade. A metal blade allows a movement of the busbars with respect to the PCB caused by vibrations without negatively influencing the solder connection. A metal blade can easily be formed such to include further damping elements for damping the vibrations. The metal blade is also thin so that low solder temperatures, lower pre-heat temperatures and times, and lower soldering times are sufficient for a reliable solder connection of the connectors and the PCB.

In one embodiment, the at least one first connector and/or the at least one second connector comprises a distal end which provide the electrical interface of the busbar assembly to the PCB. In one embodiment, the step of mounting the busbar assembly on the PCB comprises the step of electrically connecting the at least one first connector and/or the at least one second connector to the PCB. In one embodiment, the busbar assembly on the PCB is electrically connected to the at least one first connector and/or the at least one second connector to the PCB by soldering the electrical interface and/or the distal end to the PCB. Preferably, a bulk soldering technique is used, such as wave soldering, selective soldering. In one embodiment, the electrical interface and/or the distal end of each connector is configured either for being inserted in a through-hole of the printed circuit board and being soldered in this through-hole or for a surface-mounted technology (SMT). In the latter case, the electrical interface and/or the distal end of each connector is designed such to lay on the top layer of (soldering pads of the conductor tracks of) the PCB so that they can go through an SMT soldering process.

In one embodiment, the PCB comprises at least one through hole connected with at least one of the conductor tracks of the PCB, wherein the distal end of the at least one first connector and/or of the at least one second connector extends through the at least one through hole. Preferably, the distal end is soldered in the through-hole. The through-hole through the PCB comprises preferably an electrically conductive wall electrically connected to the conductor track which is connected to the distal end of the respective connector.

In one embodiment, the at least one first connector and/or of the at least one second connector are soldered to the PCB. Preferably are soldered in a through-hole of the PCB or with a SMT technology. Preferably, the connectors of the busbar assembly (and the other electrical components) are soldered on the PCB with a bulk soldering technology, like wave soldering. This allows an industrialized fixation of the busbar assembly in a very short time.

In one embodiment, the at least one first connector and/or the at least one second connector comprise a damping element between the first busbar and/or the second busbar, respectively and the PCB, in particular a damping form formed such to allow a movement of the first busbar and/or the second busbar with respect to the PCB.

In one embodiment, the first busbar has a rectangular cross-section with a large side and a small side. In one embodiment, the second busbar has a rectangular cross-section with a large side and a small side.

In one embodiment, the at least first connector is connected to the large side of the first busbar, and/or the at least second connector is connected to the large side of the second busbar. In one embodiment, the at least one first connector extends beyond the small side of the first busbar and/or in the direction perpendicular to the small side of the first busbar and/or in the direction towards the PCB. In one embodiment, the at least one second connector extends beyond the small side of the second busbar and/or in the direction perpendicular to the small side of the second busbar and/or in the direction towards the PCB.

In one embodiment, the first busbar and the second busbar are arranged such in the busbar assembly that, when the busbar assembly is mounted on the PCB, the small side of the first busbar and the second busbar face the PCB. In one embodiment, the first busbar and the second busbar are arranged such in the busbar assembly that, when the busbar assembly is mounted on the PCB, the large side of the first busbar and the second busbar is perpendicular to the PCB. In one embodiment, the first busbar and the second busbar are arranged such in the busbar assembly that the large side of the first busbar faces the large side of the second busbar. In one embodiment, the first busbar and the second busbar are arranged such in the busbar assembly that the large side of the first busbar faces or is parallel to the large side of the second busbar. One or a combination of two or more of the described arrangements of the busbars in the busbar assembly provide for a space saving and stable arrangement of the busbars.

In one embodiment, the busbar assembly comprises further a busbar housing for holding the first busbar and the second busbar. The busbar housing has several functions. In one embodiment, the busbar housing is configured to isolate the first busbar and the second busbar from each other. In one embodiment, the busbar housing is configured to position the first busbar and the second busbar relative to each other in the busbar assembly.

In one embodiment, the busbar housing comprises a first wall, a second wall and a third wall, wherein the second wall is arranged between the first wall and the third wall, wherein the first busbar is arranged between the first wall and the second wall and the second busbar is arranged between the second wall and the third wall. This allows to isolate the first busbar from the second busbar by the second wall. The first and third wall isolate the busbars from other electric components on the PCB and/or from the housing. The busbar housing comprises preferably a fourth wall arranged between the first and third wall, connecting the first, second and third wall and/or covering one of the two small sides of each busbar, preferably the small sides of the busbars facing away from the PCB. Preferably, one side of the busbar housing is open to insert the first busbar and the second busbar. The space between the first and the second wall forms a first recess for hosting the first busbar. Preferably, the first busbar has a fixed position in the first recess. The space between the third and the second wall forms a second recess for hosting the second busbar. Preferably, the second busbar has a fixed position in the second recess.

In one embodiment, the busbar housing comprises at least one form-fit-element and the PCB comprises at least one counterpart-form-fit-element, wherein the for housing the at least one form-fit-element and the at least one counterpart-form-fit-element are formed such that the busbar assembly or the busbar housing can be positioned in (only) one mounting position on the PCB by inserting the at least one form-fit-element in the at least one counterpart-form-fit-element or vice-versa. This allows a stable arrangement of the busbar assembly on the PCB. This facilitates the placement and soldering during manufacturing and improves the stability of the busbar assembly mounted on the PCB.

In one embodiment, the busbar housing comprises at least one screw openings for fixing the busbar housing to the PCB by screws. This facilitates the placement and soldering during manufacturing and improves the stability of the busbar assembly mounted on the PCB, in particular in combination with the previously mentioned form-fit-elements.

In one embodiment, the busbar housing comprises at least one first snap-fit element for fixing the first busbar in a final position in the busbar housing and/or the busbar housing comprises at least one second snap-fit element for fixing the second busbar in a final position in the busbar housing. This allows a quick and reliably manufacturing of the busbar assembly.

In one embodiment, the busbar housing is a separate piece from a housing of the filter. The busbar housing is connected to the PCB and not to the housing of the filter.

In one embodiment, the filter comprises a third busbar.

In one embodiment, the at least one electrical component mounted on the PCB is connected via at least one conductor track of the PCB with at least one of the first busbar and the second busbar of the busbar assembly mounted on the PCB.

In one embodiment, the at least one electrical component comprises at least one capacitor.

In one embodiment, the at least one capacitor comprises at least one X-capacitor connected between the first busbar and the second busbar.

In one embodiment, the at least one capacitor comprises three X-capacitors connected in delta or star-connection between the first busbar, the second busbar and the third busbar.

In one embodiment, the at least one capacitor comprises at least one Y-capacitor connected between the first busbar and an earth conductor track of the PCB, between the second busbar and the earth conductor track, and/or between the third busbar and the earth conductor track.

In one embodiment, the filter comprising at least one inductor formed by a magnetic core around the first busbar and the second busbar.

In one embodiment, the PCB comprises an opening under the busbar assembly. Preferably, the magnetic core extends through the opening under the busbar assembly.

In one embodiment, the magnetic core is formed by two c-cores.

In one embodiment, the filter comprises a first inductor formed by a magnetic core around the first busbar, wherein the first busbar comprises a first first contact point between a first terminal of the first busbar and the first inductor and/or a second first contact point between the first inductor and a second terminal of the first busbar, wherein the first busbar comprises a first second contact point between a first terminal of the second busbar and the first inductor and/or a second second contact point between the first inductor and a second terminal of the second busbar.

In one embodiment, the at least one electrical component comprises at least one capacitor, wherein the at least one capacitor comprises one or more of the following:
- a first X-capacitor between the first first contact point and the first second contact point, and/or
- a second X-capacitor between the second first contact point and the second second contact point, and/or
- a first Y-capacitor between the first first contact point and an earth conductor track, and/or
- a second Y-capacitor between the first second contact point and the earth conductor track, and/or
- a third Y-capacitor between the second first contact point and an earth conductor track, and/or
- a fourth Y-capacitor between the second second contact point and the earth conductor track.

In one embodiment, the at least one electrical component comprises at least one resistor, wherein the at least one resistor comprises one or more of :
- a first resistor between the first first contact point and the second second contact point, and/or
- a second resistor between the second first contact point and the second second contact point.

In one embodiment, the filter comprises a second inductor formed by a magnetic core around the first busbar and the second busbar, wherein the first busbar comprises the second first contact point between the first inductor and the second inductor, a third first contact point between the second terminal of the first busbar and the second inductor, wherein the second busbar comprises the second second contact point between the first inductor and the second inductor, a third second contact point between the second terminal of the second busbar and the second inductor.

In one embodiment, the at least one capacitor comprises one or more of the following:
- a third X-capacitor between the third first contact point and the third second contact point, and/or
- a fifth Y-capacitor between the third first contact point and an earth conductor track, and/or
- a sixth Y-capacitor between the third second contact point and the earth conductor track.

In one embodiment, the at least one electrical component comprises at least one resistor, wherein the at least one resistor comprises a (third) resistor between the third first contact point and the third second contact point.

In one embodiment, the at least one electrical component comprises at least one resistor, wherein the at least one resistor comprises a resistor in series with one or more of the Y-capacitors (between the earth conductor track and one of the respective contact points).

In one embodiment, magnetic core is formed as a magnetic toroidal core, wherein the first and second busbars are led through the ring opening of the magnetic toroidal core. In one embodiment the toroidal core is plugged onto a projection of the PCB. In one embodiment, the toroidal core is formed by two core-halfs, e.g. two c-cores or one U-core one I-core. The first core half is preferably mounted from a first side of the PCB and the second core half is mounted from a second side of the PCB.

In one embodiment, the magnetic core comprises an intermediate magnetic core arranged in between the first busbar and the second busbar. Preferably, the intermediate core forms a third magnetic sub-core. Preferably, the intermediate core and/or the third magnetic sub-core is part of the busbar assembly and/or is hold or received in a recess of the busbar housing between the first busbar and the second busbar. The intermediate magnetic core allows to filter also differential mode noise currents by the inductor.

In one embodiment, the magnetic core together with the first and second busbars forms a current-compensated inductor, i.e. the inductor is a current-compensated inductor or a common mode choke.

In one embodiment, the filter is a passive filter. The passive filter comprises preferably at least one common mode choke and at least one of an x-capacitor and two y-capacitors.

In one embodiment, the filter is an active filter. The active filter (in particular the PCB) comprises a noise sensing section for sensing the noise in the first and second busbar, a gain section for generating a noise compensation based on the sensed noise and an injection section for injecting the noise compensation in the first and/or second busbar. Preferably the noise sensing section is a current transformer for sensing the noise current in the first and/or second busbar. Preferably, the injection section is a capacitor for injecting the noise compensation in the first and/or second busbar.

In one embodiment, the at least one magnetic core together with the first and second busbars or the inductor forms a current transformer as inductor in order to convert noise currents in the first and second busbars into a measurement current in an auxiliary winding.

In one embodiment, the at least one capacitor comprises a first coupling capacitor, in order to input a compensation current generated on the basis of a measurement current into the first busbar, and a second coupling capacitor, in order to input the compensation current into the second busbar.

In one embodiment, the first and second busbars have in each case a first end having a first connection terminal and a second end having a second connection terminal. In one embodiment, the first end and the second end of the first and second busbars in each case project beyond the PCB.

In one embodiment, the filter comprises a metallic housing, wherein the housing has at least one ground potential area, wherein the PCB has at least one ground conductor track area, wherein each of the at least one ground potential area of the housing is pressed onto a corresponding ground conductor track area by securing means and a ground connection from the PCB to the housing is thus produced.

In one embodiment, the filter is designed for a power range of greater than 500 watts and/or for a current range of greater than 50 A.

In one embodiment, the filter is designed for a DC network.

In one embodiment, the filter is designed for a three-phase AC network.

In one embodiment, the filter is used in a DC network of an electrically driven car. Preferably, between the battery and a converter (preferably of a charging interface).

### Brief Description of the Drawings

The invention will be better understood with the aid of the description of an embodiment given by way of example and illustrated by the figures, in which:
Fig. 1 shows a circuit of a first exemplary embodiment of a filter.
Fig. 2 shows a three-dimensional view of a first busbar of the first exemplary embodiment of the filter.
Fig. 3 shows a three-dimensional view of a busbar assembly of the first exemplary embodiment of the filter.
Fig. 4 shows a three-dimensional view of the busbar assembly mounted on a printed circuit board of the first exemplary embodiment of the filter
Fig. 5 shows a three-dimensional view of the busbar assembly and the electric components mounted on the printed circuit board of the first exemplary embodiment of the filter.
Fig. 6 shows a three-dimensional view of the busbar assembly before being mounted on the printed circuit board with the electrical components of the first exemplary embodiment of the filter.
Fig. 7 shows a three-dimensional view of the busbar assembly, the printed circuit board, the electrical components, a housing and a first half of the magnetic cores of the first exemplary embodiment of the filter.
Fig. 8 shows a three-dimensional view of the busbar assembly, the printed circuit board, the electrical components, the housing and a second half of the magnetic cores of the first exemplary embodiment of the filter.
Fig. 9 shows a three-dimensional view the first exemplary embodiment of the filter.
Fig. 10 shows a circuit of a second exemplary embodiment of a filter.
Fig. 11 shows a circuit of a third exemplary embodiment of a filter.

### Detailed Description of possible embodiments of the Invention

The filter is configured damp electromagnetic noise at least in a certain frequency range. The filter can be an electromagnetic interference (EMI) filter. The frequency range of such an EMI filter is preferably between 150 kHz and 30 MHz, however other frequency ranges as mentioned below are possible. The filter can also be an electromagnetic compatibility (EMC) filter, a harmonics filter, power quality filter, etc.. The frequency range of such an filter is in one embodiment higher than 50 Hz, in one embodiment higher than 70 Hz, in one embodiment higher than 100Hz, in one embodiment higher than 1kHz, in one embodiment higher than 2 kHz, in one embodiment higher than 2,5 kHz, in one embodiment higher than 3 kHz, in one embodiment higher than 8kHz, in one embodiment higher than 9 kHz, in one embodiment higher than 100 kHz, in one embodiment higher than 150kHz, in one embodiment higher than 10 MHz, in one embodiment higher than 30 MHz, in one embodiment higher than 1 GHz, in one embodiment higher than 2 GHz. The frequency range of such an filter is in one embodiment lower than 3 GHz, in one embodiment lower than 2 GHz, in one embodiment lower than 1 GHz, in one embodiment lower than 30 MHz, in one embodiment lower than 10 MHz, in one embodiment lower than 9 MHz, in one embodiment lower than 3 kHz, in one embodiment lower than 2,5kHz, in one embodiment lower than 2 kHz, in one embodiment lower than 1 kHz. The frequency range indicates a frequency range in which the filter damps the electromagnetic noise, i.e. it has a damping factor larger than 1dB, preferably larger than 2dB, preferably larger than 3dB.

The filter is preferably configured for a DC-network with two conductors/busbars. However, the filter can equally be applied to a three-phase AC-network with three conductors/busbars or to any net with more than three conductors/busbars. The described filter is a passive filter. However, the invention can also be applied to an active filter. The filter is preferably designed for a power range larger than 500 W and/or a (AC or DC and/or nominal) current larger than 50 A, preferably larger than 100 A, preferably larger than 200 A.

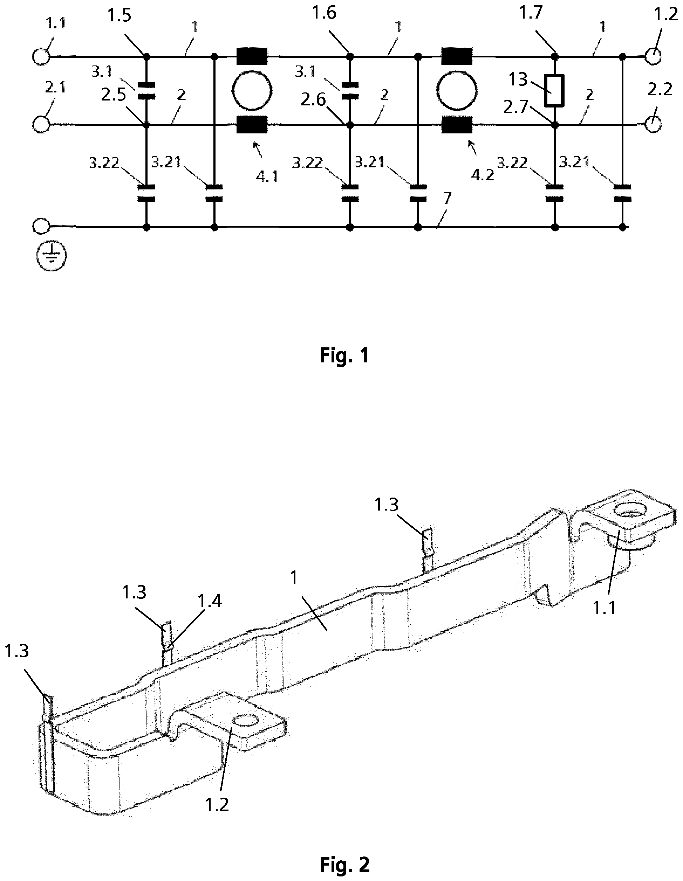

Figures 1 to 9 show a first exemplary embodiment of a filter according to the invention. The filter is configured for a DC-network. Preferably, the filter is an EMI filter. However, the features described below can also be applied for other filters and for other networks.

The filter comprises a PCB 5, a busbar assembly 6 and at least one electrical component.

The printed circuit board 5 is a board composed of an electrically insulating material with conductor tracks for connecting the electrical components of the filter. In one embodiment, the printed circuit board 5 has a first side and a second side opposite the first side. The first and second side are preferably parallel to a plane of the PCB 5, in the following the PCB plane. The direction perpendicular to the PCB plane is in the following called PCB normal. In one embodiment, the printed circuit board 5 has at least one lateral side, which is or are arranged at right angles to the normal to the printed circuit board plane (plane of the first and second sides). In one embodiment, the printed circuit board 5 has four lateral sides. In one embodiment, the printed circuit board 5 has one or more openings for receiving a magnetic core of an inductor described in more detail below. The opening 5.1 is preferably closed on all sides by the PCB 5 such that the magnetic core must be open or made of two-halfs to be formed around the busbars 1 and 2. However, the opening can also be formed at the borders of the PCB such that a toroidal magnetic core formed of one piece can be moved/plugged on the busbars 1 and 2 and in the opening(s) of the PCB 5 from one lateral side of the PCB 5. The conductor tracks can be realized just on the first side, just on the second side or on both sides.

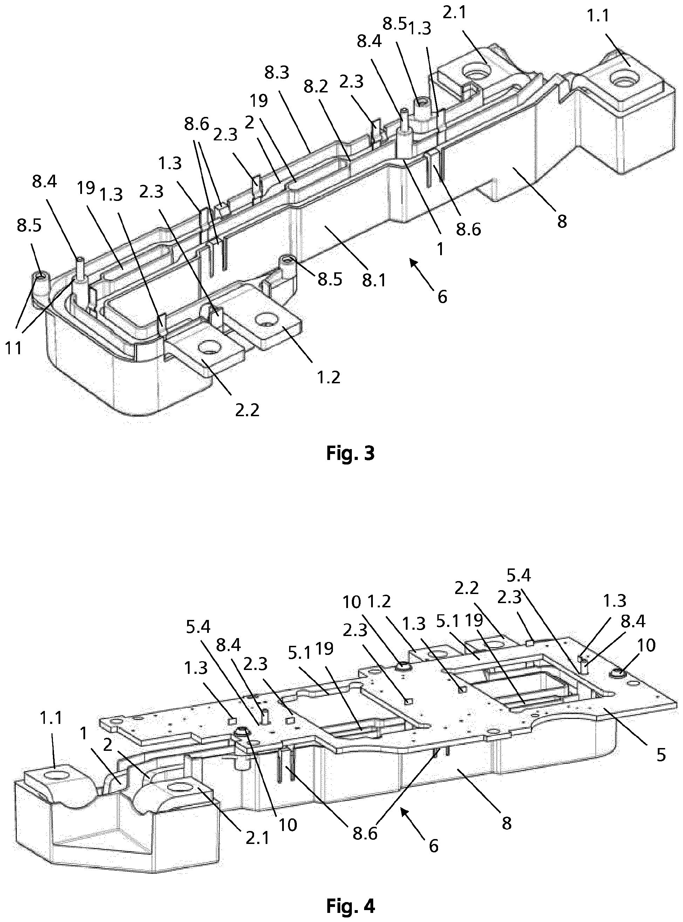

The busbar assembly comprises a first busbar 1 and a second busbar 2. Fig. 3 shows an example of the busbar assembly 6.

The first busbar 1 and the second busbar 2 are composed of an electrically conductive, preferably metallic, preferably copper material. The busbars 1 and 2 are rigid (in contrast to flexible cables and wires). The busbars 1 and 2 are designed for conducting the system current. This is preferably a DC current. Preferably, the cross-sectional area of each busbar 1 and 2 is at least ten square millimeters, preferably at least 20 square millimeters, preferably at least 30 square millimeters, preferably at least 40 square millimeters. The busbars 1, 2 are preferably extruded in a form suitable for a housing of the filter described later, the PCB 5 and/or the filter. The first busbar 1 has a first end with a first connection terminal 1.1 and a second end with a second connection terminal 1.2. The second busbar 2 has a first end with a first connection terminal 2.1 and a second end with a second connection terminal 2.2. The connection terminals 1.1, 1.2, 2.1, 2.2 have preferably a connection interface for fixing a cable or another busbar. The connection interface can be hole through the busbar 1, 2. The hole can comprise a thread. Many other connection interfaces are possible. The filter can be integrated on long busbars 1, 2 which go through several devices of a system. In this case, the connection terminals 1.1, 1.2, 2.1, 2.2 can also be the passage from the filter to the next device on the busbar. In one embodiment, the cross section of the busbars 1, 2 at right angles to the current direction is rectangular. In one embodiment, the first busbar has four lateral sides (radially to the current direction) and two distal sides. The four lateral sides have preferably two opposed large sides and two opposed small sides (due to the rectangular cross-section). The two small sides comprise preferably a first small side and a second small side. The two large sides comprise preferably a first large side and a second large side.

The busbars 1, 2 are arranged in the busbar assembly 6 such that the busbars 1, 2 form one unit or component. Preferably, the busbar assembly 6, i.e. this unit, is formed as a standard PCB component. This unit or component can then be fixed and/or electrically connected to the PCB 5, in particular to the conductor tracks of the PCB 5. The busbars 1, 2 are arranged in the busbar assembly such that the busbars 1, 2 have a fixed position relative to each other, before being mounted with the busbar assembly 6 on the PCB 5 and/or after being mounted with the busbar assembly 6 on the PCB 5. In one embodiment, the first busbar 1 and the second busbar 2 are arranged such in the busbar assembly 6 that, when the busbar assembly is mounted on the PCB 5:
- the first small side of the first busbar and the first small side of the second busbar face the PCB 5, and/or
- the large side(s) of the first busbar and/or the large side(s) of the second busbar is perpendicular to the PCB 5, and/or
- the (small side of the) first busbar and/or the (small side of the) second busbar is arranged at a distance to the PCB 5 (such that the conductor tracks of the PCB 5 can pass under the busbar 1, 2).

In one embodiment, the first busbar 1 and the second busbar 2 are arranged such in the busbar assembly 6 that the first large side of the first busbar 1 faces first large side of the second busbar 2. In one embodiment, the first busbar 1 and the second busbar 2 are arranged such in the busbar assembly 6 that the first and/or second large side of the first busbar 1 is parallel to the first and/or second large side of the second busbar 2.

The busbar assembly 6 comprises preferably further at least one first connector 1.3 and/or at least one second connector 2.3. Each first connector 1.3 is configured to (electrically) connect (a first connection point of) the first busbar 1 with a conductor track of the PCB 5. Each second connector 1.3 is configured to connect (a connection point of) the first busbar 1 with a conductor track of the PCB 5.

In the first embodiment of the filter in Fig. 1, the first busbar 1 has a first first connection point 1.5, a second first connection point 1.6, a third first connection point 1.7 and the second busbar 2 has a first second connection point 2.5, a second second connection point 2.6, a third second connection point 2.7. Each first connection point 1.5, 1.6, 1.7 of the first busbar 1 is connected via a (separate) first connector 1.3 with (a separate conductor track of) the PCB 5. Fig. 2 shows the first busbar 1 with the three connectors 1.3. Each second connection point 2.5, 2.6, 2.7 of the second busbar 2 is connected via a (separate) second connector 2.3 with (a separate conductor track of) the PCB 5. Other filter embodiments can have (only) one or (only) two connection points or can have four or more connection points for the first busbar 1 or for the second busbar 2 depending on the complexity of the circuit.

The connector 1.3, 2.3 will be described in general for a busbar 1, 2 without distinguishing between the first and second busbar 1, 2 and between the first and second connector 1.3, 2.3. The subsequent features of the connector apply to one, each, some or all of the connectors 1.3, 2.3. Preferably, all connectors 1.3, 2.3 are equal. The connector 1.3, 2.3 is conductive to connect the busbar 1, 2 with the (conductor track(s) of the) PCB 5. The connector 1.3, 2.3 has preferably a proximal end and a distal end (opposed to the proximal end).

The proximal end of the first connector 1.3 is conductively connected with the first busbar 1 (at the respective contact point). Fig. 2 shows the first busbar 1 with the first connectors 1.3 connected to the first busbar 1. The proximal end of the second connector 2.3 is conductively connected with the second busbar 2 (at the respective contact point). The connector 1.3, 2.3 is preferably a separate part from the busbar 1, 2, respectively. Therefore, the proximal end of the connector 1.3, 2.3 is fixed to the respective busbar 1, 2 (at the respective connection point) such as to provide a conductive connection between the connector 1.3, 2.3 and the busbar 1, 2. The proximal end of the connector 1.3, 2.3 can be fixed to the respective busbar 1, 2 by soldering, welding, press-fit, or other means. The connector 1.3, 2.3 can however also be an integral part of the respective busbar 1, 2. For example, the distal end of the connector can be extruded together with the busbar 1, 2. The proximal end of the connector 1.3, 2.3 would in this case be the busbar 1, 2 itself. However, such extruded distal ends or pins have the disadvantage of being rigid and do not damp vibrations. Therefore, the risk for a solder crack at the connection between the connector 1.3, 2.3 and the PCB 5 is much higher.

The distal end of the connector 1.3, 2.3 is configured to be soldered to the PCB 5. The distal end of the connectors 1.3, 2.3 provides the electrical interface for the busbar assembly to the PCB 5 such that the busbar assembly 6 can be treated as a standard PCB component. In one embodiment, the distal end of the connectors 1.3, 2.3 is configured for being inserted in a through-hole of the PCB 5 and for being soldered in this through-hole (through hole technology). The through-hole is preferably a plated through-hole, i.e. with conductive inner walls connected to a conductor track of the PCB 5. In one embodiment, the distal end of the connectors 1.3, 2.3 is configured for being inserted in a through-hole of the PCB 5 and for being soldered in this through-hole (through hole technology). Preferably, the distal end of the connector 1.3 has a lengthy cross-sectional form, i.e. the cross-sectional form is such that a first width in a first direction is larger than a second width in a second direction. Preferably, the first width is two time, preferably three times, preferably 4 times, preferably 5 times, preferably 10 times larger than the second width. Preferably, the first direction of the first width extends perpendicular to the second direction of the second width. This allows a good contact and/or soldering to the long lateral side of the corresponding through-hole while allowing nevertheless a tolerance in the through-hole of the PCB 5 at the ends in the lengthy direction of the through-hole. Preferably, the longitudinal extension of the through-hole is larger than the first width of the distal end of the connector 1.3 such that the connector 1.3 has some tolerance for being inserted in the through-holes of the PCB 5. Since the connectors 1.3, 2.3 may not be perfectly be positioned on the busbars 1, 2 and since the busbars 1, 2 might not be perfectly be positioned in the busbar housing 8, this allows to guarantee that the connectors 1.3 and 2.3 enter in the corresponding through-holes of the PCB 5. However, in another less preferred embodiment, the distal end of the connector 1.3 could also be a classic connector pin with a circular or n-gonal cross-sectional form. In one embodiment, the distal end of the connectors 1.3, 2.3 is configured for a surface mount technology (SMT), e.g. the distal end of the connectors 1.3, 2.3 provide a soldering tag which lays flat on (corresponding solder pads of) the PCB 5.

Preferably, the connector 1.3, 2.3 is made of a flexible material which allows a certain movement between the busbar 1, 2 and the PCB 5. This allows to damp the vibrations such that a connection break, like solder cracks of the connectors 1.3, 2.3 to the busbar 1, 2 or to the PCB 5 is avoided. Preferably, the connector 1.3, 2.3 is made of a conductive blade material, preferably a metal blade. The blade can be made of a thin metal sheet. Since the blade is pliable, a certain flexibility of the connector 1.3, 2.3 is realized. Preferably, the connector 1.3, 2.3 is made of a metal. Preferably, the connector 1.3, 2.3 comprises further a damping element 1.4 for (further damping) the vibrations between the busbar 1, 2 and the connector 1.3, 2.3. The damping element 1.4 is preferably arranged between the proximal end and the distal end of the connector 1.3, 2.3. In the case of the blade as connector 1.3, 2.3, the damping element can be made by forming the blade in a non-straight form such that the length of the blade between the busbar 1, 2 and the PCB 5 is longer than the distance between the PCB 5 and the busbar 1, 2. This is realized by small part between the proximal and distal end which makes a detour instead of following the straight line between the distal and proximal end. The form to extend the length of the blade can be a semi-circle (as in Fig. 2), a triangle, a meander-form, and many more. The blade form of the connector 1.3, 2.3 at the proximal end allows a large connection surface with the busbar 1, 2, preferably with one of the large sides of the busbars 1, 2. This provides a reliable physical connection and a good conductive connection. The blade form of the connector 1.3, 2.3 at the distal end allows lengthy through-holes in the PCB 5. The through-holes can be made a little bit longer than the width of the blade such that there is some tolerance with respect to the position of the connectors 1.3, 2.3 in the busbar assembly 6. This facilitates mounting the busbar assembly 6 on the PCB 5. The distal end of the connector 1.3, 2.3 can however also be formed as a pin to use classic round PCB inserts. For example, the blade can be rolled at the distal end to form a round pin for a PCB insert.

The first connector 1.3 is preferably connected to the first busbar 1 offset (in the direction of the current) with respect to the connection to the second busbar 2 of the second connector 2.3 corresponding to the same connection point / position with respect to the at least one inductor. The first connector 1.3 of the first first contact point 1.5 is preferably connected to the first busbar 1 offset (in the direction of the current) with respect to the connection to the second busbar 2 of the second connector 2.3 of the first second contact point 2.5. The first connector 1.3 of the second first contact point 1.6 is preferably connected to the first busbar 1 offset (in the direction of the current) with respect to the connection to the second busbar 2 of the second connector 2.3 of the second second contact point 2.6. The first connector 1.3 of the third first contact point 1.7 is preferably connected to the first busbar 1 offset (in the direction of the current) with respect to the connection to the second busbar 2 of the second connector 2.3 of the third second contact point 2.7.

The busbar assembly 6 comprises preferably a busbar housing 8. Fig. 3 to 6 shows the busbar assembly 6 with the busbar housing 8.

The busbar housing 8 has preferably the function of holding the first busbar 1 and the second busbar 2. In one embodiment, the busbar housing 8 comprises a first wall 8.1, a second wall 8.2 and a third wall 8.3, wherein the second wall 8.2 is arranged between the first wall 8.1 and the third wall 8.3. The first wall 8.1, the second wall 8.2 and the third wall 8.3 are preferably arranged parallel to each other. Preferably, the busbar housing 8 comprises a fourth wall connecting the first wall 8.1, the second wall 8.2 and the third wall 8.3. The fourth wall is preferably arranged perpendicular to the first wall 8.1, the second wall 8.2 and the third wall 8.3. The busbar housing 8 comprises preferably further an open side for inserting the busbars 1, 2 in the busbar housing 8. The open side is preferably on the opposite side with respect to the fourth wall. The first wall 8.1 and the second wall 8.2 (and the fourth wall) form a (U-formed) first recess (in its cross-section) for housing the first busbar 1. The third wall 8.3 and the second wall 8.2 (and the fourth wall) form a (U-formed) second recess (in its cross-section) for housing the second busbar 2. The first busbar 1 is arranged between the first wall 8.1 and the second wall 8.2 and the second busbar 2 is arranged between the second wall 8.2 and the third wall 8.3. Preferably, the second large side of the first busbar 1 faces the first wall 8.1, the second large side of the second busbar 2 faces the third wall 8.3, the first large sides of the first busbar 1 and the second busbar 2 face the second wall 8.2, the first small sides of the first busbar 1 and the second busbar 2 face open side and/or the second small sides of the first busbar 1 and the second busbar 2 face the fourth wall. Preferably, the busbar housing 8 is such that the busbars 1 are covered on all sides except on the open side (and except at the connection terminals 1.1, 1.2, 2.1, 2.2). The first busbar 1 is fixed in the first recess and/or the second busbar 2 is fixed in the second recess by at least one snap-fit element. The snap fit element is here realized by one or two levers 8.6 formed in the first wall 8.1, second wall 8.2 and/or third wall 8.3. The lever head of the levers 8.6 is formed such that it will be pressed away from the respective recess or busbar 1, 2, when the busbar 1, 2 is pressed (from the open side) into the respective recess. This is realized by a wedge profile of the lever head. This movement opens the open side of the respective recess to insert the busbar 1, 2 in the respective recess. Once, the busbar 1, 2 is fully inserted, the lever 8.6 goes back in its original position and blocks the busbar 1, 2 in the respective recess. Since the levers 8.6 work like a spring, they allow a certain movement of the busbars 1, 2, but damp such a movement by the force of the lever 8.6 which presses the busbar 1, 2 back in its position. The levers 8.6 are just an example for a snap-fit element. The snap-fit element is just one example for fixing the busbars 1, 2 in (the respective recess of) the busbar housing 8. Other fixation elements like screws, form-fit, press-fit, etc. can be used.

The busbar housing 8 has preferably the function of holding the first busbar 1 and the second busbar 2 in a fixed relationship relative to each other. This is preferably achieved by the first and second recess described above. For the function of fixing the busbars 1, 2 relative to each other, the busbar housing 8 can also be very simple, e.g. just one or more relative fastener(s) between the two busbars 1, 2.

The busbar housing 8 has preferably the function of holding the first busbar 1 and the second busbar 2 in a fixed relationship relative to the PCB 5. The fixed relationship provided by the busbar housing 8 should be configured to allow the positions of the busbars 1, 2 to each other and to the PCB 5 of the busbar assembly 6 as described above. The fixed relationship however shall preferably allow some (damped) small movements of the busbars 1, 2 with respect to the housing for not transmitting the vibrations of the busbars 1, 2 to the PCB 5, in particular to the solder joints between the connectors 1.3, 2.3 and the PCB 5. For the function of fixing the positional relationship of the two busbars 1, 2 with respect to the PCB 5, the busbar housing 8 has at least one positioning element. The at least one positioning element comprises preferably at least one form-fit-element for positioning the busbar assembly 6 or the busbar housing 8 in (only) one position on the PCB 5. The at least one form-fit-element 8.4 is here at least one pin (here two pins). The PCB 5 comprises at least one counterpart-form-fit-element which is here a hole 5.4 for receiving the pin 8.4. The at least one form-fit-element and the at least one counterpart-form-fit-element are formed such that the busbar assembly 6 or the busbar housing 8 can be positioned in (only) one mounting position on the PCB 5 by inserting the at least one form-fit-element 8.4 in the at least one counterpart-form-fit-element 5.4 or vice-versa. The at least one form-fit-element 8.4 and the at least one corresponding counterpart-form-fit-element 5.4 are preferably formed such that they engage before the at least first connector 1.3 and/or the at least one second connector 2.3 enter their corresponding through-hole of the PCB 5. This facilitates inserting the connectors 1.3, 2.3 in their corresponding through-holes without damaging the connectors 1.3, 2.3. In one embodiment, the at least one positioning element of the busbar housing 8 comprises at least one fixation element 8.5 which allows to fix the busbar assembly 6 or the busbar housing 8 in the mounting position to the PCB 5. The fixation element 8.5 could be for example a screw means, like a screw-openings, preferably a threaded screw opening. The PCB 5 has preferably respective fixation elements for fixing the fixation elements 8.5 to the fixation elements of the PCB 5. The fixation elements of the PCB 5 are here simple holes which can be fixed to the fixation elements 8.5 by screws 10. In another embodiment, the fixation elements can however also be combined with the form-fit-elements by snap-fit elements. The at least one positioning element comprises preferably a support surface 11 which lays on the surface of the PCB 5, when mounted on the PCB 5. The support surface 11 is here provided by a step in the form-fit-element 8.4 and/or by the fixation means, i.e. the border of the screw opening 8.5. Thus, the busbar housing 8 provides a simple positioning of the busbar assembly 6 on the PCB 5. The Position of the busbar assembly 6 on the PCB 5 is such that the distal ends of the connectors 1.3, 2.3 are arranged at respective solder positions on the PCB 5. In the embodiment of through-holes, the distal ends of the connectors 1.3, 2.3 extend through the corresponding through-holes in the PCB 5. In the embodiment of SMT, the distal ends of the connectors 1.3, 2.3 lay on the surface of the PCB 5 on corresponding solder pads.

The busbar housing 8 is preferably configured to isolate the first busbar 1 and the second busbar 2 from each other. This is provided by the second wall 8.2 between the two busbars 1, 2. However, other realizations of the busbar housing 8 are possible to realize this function.

The busbar housing 8 is preferably configured to receive an intermediate magnetic core of an inductor 4.1, 4.2 between the first busbar 1 and the second busbar 2. The intermediate magnetic core is preferably a sub-core of the magnetic core 14 of the inductor 4.1 or 4.2 described later. However, the intermediate magnetic core can be also a core portion of the magnetic core 14 or of one or both of the sub-cores 14.1, 14.2. Preferably, the busbar housing 8 comprises between the first busbar 1 and the second busbar 2 a recess 19 for receiving the intermediate magnetic core. Preferably, the recess 19 is realized such that it holds the intermediate magnetic core in a fixed position. This can be achieved by a snap-fit or press-fit in the recess 19. Preferably, the second wall 8.2 splits in the region of the inductor 4.1 or 4.2 in two second sub-walls for creating the recess 19 between the two second sub-walls. The busbars 1 and/or 2 can be formed such to increase the distance between them to host the recess 19 and/or the intermediate magnetic core in between. The recess 19 is preferably open on the side of the busbar housing 8 pointing towards the PCB 5. Preferably, the recess 19 is closed on its other side. The intermediate magnetic core, in particular in the form of a separate sub-core of the magnetic core 14, can thus already be inserted in the recess 19 when forming the busbar assembly 6. However, the intermediate magnetic core can also be mounted later, e.g. when being a portion of the magnetic core 14 or of one or two of the sub-cores 14.1 and 14.2.

The busbar housing 8 is preferably one piece realizing one or more or all of the above-mentioned functions. However, it would also be possible to realize the busbar housing as different pieces for different functions described above. Preferably, the busbar housing 8 is a separate piece from a housing 12 of the filter. The busbar housing 8 is fixed to the PCB 5 and not to the housing 12 of the filter.

The busbar assembly 6 forms one piece or component which is now mounted to the PCB 5. "Mount" shall include an electrical connection of the busbar assembly 6 to (the conductor tracks of) the PCB 5 and a mechanical fixation to the PCB 5. In a preferred embodiment, the busbar assembly 6 can be treated as a standard PCB component. A standard PCB component is defined as a component with:
- one or more electrical functions (here conducting the main system current, here a DC current in the positive busbar and the negative busbar),
- a suitable shape and interface so that the standard PCB component can be placed on a PCB providing mechanical stability before and after the soldering process,
- an electrical interface that can be soldered on a PCB thanks to a standard industrial process, like bulk soldering.

The positional elements of the busbar housing 8 provide the second definition feature and the distal ends of the connectors 1.3, 2.3 realize the third definition feature. Fig. 4 to 6 show the mounting of the busbar assembly 6 on the PCB 5. The form-fit elements 8.4 of the busbar assembly 6 are arranged in the counterpart-form-fit elements 5.4 of the PCB 5. The PCB 5 and the busbar assembly 6 are fixed to each other by the fixation means 8.5 and 10. The connectors 1.3, 2.3 are conductively connected to respective conductor tracks of the PCB 5. The busbar assembly 6 is preferably placed on the first side of the PCB 5. The connectors 1.3, 2.3 are preferably soldered to respective conductor tracks of the PCB 5. Preferably, the distal ends of the connectors 1.3, 2.3 extend (from the first side of the PCB 5) through through-holes of the PCB 5 (to the second side of the PCB 5). The distal ends of the connectors 1.3, 2.3 are soldered on the second side of the PCB 5. The soldering process will be described in more detail below.

The at least one electrical component is mounted also on the PCB 5. The at least one electrical component is connected via at least one conductor track with the first busbar 1 and/or the second busbar 2 (via the connectors 1.3, 2.3). Each or most of the at least one electrical component is electrically connected by one of the known connection technologies on the printed circuit board 5. The at least one electrical component is preferably soldered on the PCB 5. In one embodiment, the through-hole technology (THT) customary in power electronics is used, although surface-based mounting techniques such as SMT or other mounting techniques are also possible. The electrical components are preferably mounted on the first side (together with the busbar assembly 6). Preferably, at least more than 50%, preferably more than 80% of the electrical components are mounted on the first side of the PCB 5.

The at least one electrical component comprises preferably at least one capacitor. The at least one capacitor comprises preferably at least one current capacitor 3.1 (also called X-capacitor) connected between the first busbar 1 and the second busbar 2, as is shown for example in the circuit in figure 1. The at least one X-capacitor 3.1 can be arranged between the first first connection point 1.5 and the first second connection point 2.5, (first X-capacitor 3.1) and/or between the second first connection point 1.6 and the second second connection point 2.6 (second X-capacitor 3.1), and/or between the third first connection point 1.7 and the third second connection point 2.7 (third X-capacitor not present in the embodiment of Fig. 1). Alternatively or additionally, the at least one capacitor comprises a first ground capacitor 3.21 (also called Y-capacitor) which is connected between the first busbar 1 and ground 7, and/or a second ground capacitor 3.22 (also called Y-capacitor) which is connected between the second busbar 2 and ground 7, as shown for example in the circuit in figure 1. The at least one first Y-capacitor 3.21 can be arranged between the first first connection point 1.5 and ground (first first Y-capacitor), and/or between the second first connection point 1.6 and ground (second first Y-capacitor), and/or between the third first connection point 1.7 and ground (third first Y-capacitor). The at least one second Y-capacitor 3.22 can be arranged between ground and the first second connection point 2.5 (first second Y-capacitor), and/or between ground and the second second connection point 2.6 (second second Y-capacitor), and/or between ground and the third second connection point 2.7 (third second Y-capacitor). The ground is preferably realized by an earth conductor track or ground conductor track. The at least one capacitor can comprise also other capacitors, e.g. a capacitor between each busbar and an amplifier of an active filter to inject a compensation noise into the busbar. Each functional capacitor, such as, for example, the at least one current capacitor 3.1 and the at least one ground capacitor 3.21, 3.22, can itself consist of a plurality of connected individual capacitor units which are in each case individually connected to the printed circuit board 5. In general, the capacitor units of a functional capacitor are interconnected in parallel with one another by means of the conductor tracks of the printed circuit board 5. However, a series concatenation of the capacitor units is also conceivable for very high currents. Preferably, the first first Y-capacitor 3.21 and/or first second Y-capacitor 3.22 is (preferably at least 2 time, preferably at least 5 times, preferably at least 8 times) smaller than the second first Y-capacitor 3.21 and/or second second Y-capacitor 3.22. Preferably, the third first Y-capacitor 3.21 and/or third second Y-capacitor 3.22 is/are (preferably at least 2 time, preferably at least 3 times) larger than the second first Y-capacitor 3.21 and/or second second Y-capacitor 3.22. Preferably, the first first Y-capacitor 3.21 and/or first second Y-capacitor 3.22 is (preferably at least 5 time, preferably at least 10 times, preferably at least 20 times) smaller than the third first Y-capacitor 3.21 and/or third second Y-capacitor 3.22. Preferably, the at least one Y-capacitor is larger than the at least one Y-capacitors.

The at least one electrical component comprises preferably at least one resistor. The at least one resistor comprises preferably at least one resistor 13 between the first busbar 1 and the second busbar 2. The at least one resistor 13 between the first busbar 1 and the second busbar 2 can be arranged can be arranged between the first first connection point 1.5 and the first second connection point 2.5, and/or between the second first connection point 1.6 and the second second connection point 2.6, and/or between the third first connection point 1.7 and the third second connection point 2.7. Alternatively or additionally, the at least one resistor can comprise a first earth resistor (not shown) arranged between the first busbar 1 and ground and/or a second earth resistor (not shown) arranged between the second busbar 2 and ground. The at least one first ground resistor can be arranged between the first first connection point 1.5 and ground (first first ground resistor), and/or between the second first connection point 1.6 and ground (second first ground resistor), and/or between the third first connection point 1.7 and ground (third first ground resistor). The at least one first ground resistor can be arranged in series or parallel to the at least one first ground capacitor 3.21. Preferably, the at least one first ground resistor is arranged between the at least one first ground capacitor 3.21 and ground. The at least one second ground resistor can be arranged between ground and the first second connection point 2.5 (first second ground resistor), and/or between ground and the second second connection point 2.6 (second second ground resistor), and/or between ground and the third second connection point 2.7 (third second ground resistor). The at least one second ground resistor can be arranged in series or parallel to the at least one second ground capacitor 3.22. Preferably, the at least one second ground resistor is arranged between the at least one second ground capacitor 3.22 and ground. Preferably, the first first ground resistor and/or first second ground resistor is (preferably at least 2 times) larger than the second first ground resistor and/or second second ground resistor. Preferably, the third first ground resistor and/or third second ground resistor is/are (preferably at least 1.5 times) smaller than the second first ground resistor and/or second second ground resistor. Preferably, the first first ground resistor and/or first second ground resistor is (preferably at least 2 time, preferably at least 4 times) larger than the third first ground resistor and/or third second ground resistor. Preferably, the at least one ground resistor is larger than the at least one resistor between the busbars 1, 2. There could be further resistors in further arrangements.

The at least one electric component can comprise depending on the filter circuit other electrical components, like a fuse, a connector, an inductor, a diode, an amplifier, a transistor, an auxiliary winding, etc.

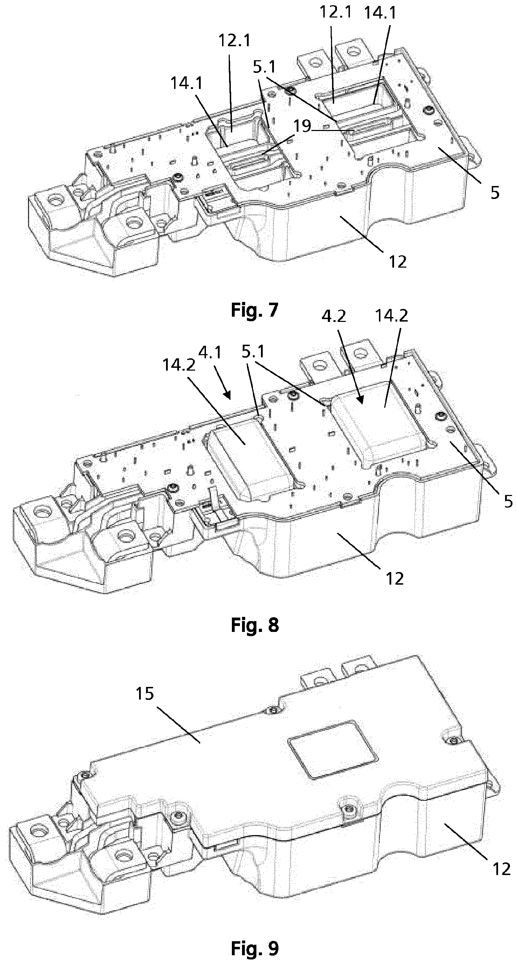

The filter comprises preferably at least one inductor 4. The inductor 4 is preferably arranged in the busbars 1, 2. This is realised by forming a magnetic core 14 around the first busbar 1 and/or around the second busbar 2. Preferably, the magnetic core 14 is formed around the first busbar 1 and around the second busbar 2 to form a current-compensated choke, a common-mode choke and/or a current transformer. The at least one magnetic core 14 is arranged preferably in a ring-shaped fashion around the first and second busbars 1 and 2 and, in the first embodiment, together with the first and second busbars 1, 2 forms a current-compensated inductor. In this case, in a ring-shaped fashion means that the magnetic core forms a complete or at least a large part of a closed curve around the first and second busbars 1 and 2, such that the magnetic core 14 forms a current-compensated inductor 4 with the two busbars 1 and 2 and the two busbars 1 and 2 are led through the ring opening shaped by the magnetic core 14. The closed curve preferably forms a rectangle or square, but in other examples may also be shaped as circle, n-gonal (polygonal) or in some other way. Preferably, the cross section of the circumferential bulge is preferably rectangular. This facilitates the securing of the magnetic core 14 on the PCB 5 or in the housing 12. In one embodiment, the magnetic core 14 is formed of at least two magnetic subparts, e.g. two C-cores 14.1, 14.2 as shown in Fig. 7 and 8. This has the advantage that at least one sub-part 14.1 can be mounted on the first side of the PCB 5 around the busbar assembly 6 or around the first and second busbar 1, 2 and that at least one other sub-part 14.2 can be mounted on the second side of the PCB 5 around the busbar assembly 6 or around the first and second busbar 1, 2 to form together a magnetic core 14 around the two busbars 1, 2. Preferably, the PCB 5 has an opening 5.1 for the magnetic core 14. This avoids that the two busbars 1, 2 or the busbar assembly 6 must be inserted in the opening of the ring-formed magnetic core. However, it is also possible to use a (closed) ring-formed magnetic core made out of one piece. In this case, the magnetic core can be supported by a projection of the PCB 5.

In a preferred embodiment, the magnetic core 14 comprises the intermediate core which is arranged between the first busbar 1 and the second busbar 2. This provides a low reluctance path for a flux generated by a differential mode noise current in the busbars 1, 2. Thus, the inductor 4 can work as a combined differential and common mode choke which filters common mode noise and differential mode noise. The intermediate magnetic core is realized a separate magnetic sub-core with respect to the magnetic core 14 forming the ring around the two busbars 1, 2 and/or with respect to the first magnetic sub-core 14.1 and the second magnetic sub-core 14.2. Preferably, the intermediate magnetic core is realized as a third sub-core of the magnetic core 14. This allows to integrate the intermediate magnetic core already in the busbar assembly 6, before mounting the busbar assembly 6. In addition, this provides an air-gap between the ring-formed magnetic core 14 and the intermediate magnetic core which reduces the probability of the magnetic core 14 to saturate. In addition, the air gap allows to tune the core performance of the inductor 4. However, in a less preferably embodiment the intermediate core could be integrated in at least one of the C-shaped sub-cores 14.1 and/or 14.2 as an E-core.

The filter shown in Fig. 1 comprises a first inductor 4.1 and a second inductor 4.2 in the main power line formed by the busbars 1, 2. The two inductors 4.1 and 4.2 define for first busbar 1 the first first connection point 1.5, the second first connection point 1.6 and the third first connection point 1.7 for potentially connecting electrical components to the first busbar 1. The two inductors 4.1 and 4.2 define for second busbar 2 the first second connection point 2.5, the second second connection point 2.6 and the third second connection point 2.7 for potentially connecting electrical components to the second busbar 2. In the circuit shown in Fig. 1, electrical components are connected to all six contact points. It is however also possible to connect electrical components just to the second first connection point 1.6 and the second second connection point 2.6 or any other subset of the mentioned contact points. It is however also possible to have only one inductor 4 or more than two inductors 4 in the main power line formed by the busbars 1, 2. In case of only one inductor 4, the third first contact point 1.7 and the third second contact point 2.7 vanish. The first inductor 4.1 is preferably smaller than the second inductor 4.2.

The at least one inductor can comprise further an inductor which is not arranged in the main power line, thus in the busbars 1, 2. The inductor would then be an electrical component mounted on the PCB 5. For example, some filter could necessitate a first ground inductor between the first busbar 1 and ground, e.g. in series or parallel to the first ground capacitor 3.21, or a second ground inductor between the second busbar 2 and ground, e.g. in series or parallel to the second ground capacitor 3.22.

The filter has preferably a housing 12. The housing 12 covers preferably (at least) the first side of the PCB 5 with the busbar assembly 6 (except for the terminals 1.1, 1.2, 2.1, 2.2) and the electrical components mounted on the first side of the PCB 5. The housing 12 comprises preferably a first housing wall which faces the first side of the PCB 5, which preferably is parallel to the first side of the PCB 5. The housing 12 comprises preferably at least one lateral housing wall between the PCB 5 and the first housing wall. The at least one lateral housing wall comprises preferably at least one recess, preferably at least two recesses for receiving the busbar assembly which projects out of the at least one or two recess(es). The portion(s) of the busbar assembly 6 projecting out of the housing 12 contain preferably the connection terminals 1.1, 1.2, 2.1, 2.2 so that the filter can be connected to the power network.

The housing 12 comprises preferably at least one core structure 12.1 for holding the at least one magnetic core 14, in particular the at least one first magnetic sub-core 14.1 in its position. The core structure 12.1 is preferably configured to hold the magnetic core 14, in particular the first magnetic sub-core 14.1 in a fixed position (at least in the directions of the PCB plane). The core structure 12.1 comprises preferably four lateral core structure walls which limit the movement of the magnetic core 14, in particular the first magnetic sub-core 14.1 in the directions of the PCB plane. The outer surfaces of the magnetic core 14, in particular of the first magnetic sub-core 14.1 are thus covered and/or in contact with the four lateral core structure walls. This fixes the position of the magnetic core 14 and/or isolates the outer surfaces of the magnetic core 14, in particular of the first magnetic sub-core 14.1 with respect to other electrical components in the filter. The core structure 12.1 or the four lateral core walls project preferably from the first housing wall and/or extend up to the PCB 5. Preferably, the core structure 12.1 and/or the four lateral core walls are arranged around the opening 5.1 in the PCB 5. The core structure 12.1 comprises preferably a distal wall opposed to the PCB 5. The distal wall is preferably parallel to the PCB plane and/or to the first housing wall. Preferably, the distal wall is provided by the first housing wall. The core structure 12.1 comprises preferably an open side which faces the PCB 5, in particular its opening 5.1. The magnetic core 14, preferably the first magnetic sub-core 14.1 can be inserted from the open side of the core structure 12.1, before mounting the housing 12 on the PCB 5. The magnetic core 14 is preferably in contact with the distal wall. The four lateral core structure walls comprise (preferably two) recess(es) for hosting the busbar assembly 6. The busbar assembly 6 extends thus through the recesses of the lateral core structure wall and through the opening of the magnetic core 14. Thus, the magnetic core 14 is arranged between the lateral magnetic core structure walls and the busbar housing 8. Preferably, the magnetic core 14, in particular the first magnetic sub-core 14.1 extends between the first wall 8.1 of the busbar housing 8 and a first, second and third lateral core structure wall, between the fourth wall of the busbar housing 8 and the second and third lateral core structure wall and the distal wall, and between the third wall 8.3 of the busbar housing 8 and a fourth lateral core structure wall and the second and third lateral core structure wall. The first, third and fourth wall of the busbar housing 8 have thus further the function to insulate the busbars 1, 2 from the magnetic core 14. The magnetic core 14, in particular the first magnetic sub-core 14.1 is preferably glued in the core structure 12.1, preferably to the distal wall.

A cover 15 covers preferably the remaining portion of the filter which is not already covered by the busbar housing 8 or the housing 12. The cover 15 covers preferably the second side of the PCB 5. The cover 15 closes preferably the open side of the housing 12. The cover 15 comprises preferably at least one core structure for holding the at least one magnetic core 14, in particular the at least one second magnetic sub-core 14.2 in its position. The core structure is preferably configured to hold the magnetic core 14, in particular the second magnetic sub-core in a fixed position (at least in the directions of the PCB plane). The core structure comprises preferably four lateral core structure walls which limit the movement of the magnetic core 14, in particular the second magnetic sub-core in the directions of the PCB plane. The outer surfaces of the magnetic core 14, in particular of the second magnetic sub-core 14.2 are thus covered and/or in contact with the four lateral core structure walls. This fixes the position of the magnetic core 14 and/or isolates the outer surfaces of the magnetic core 14, in particular of the second magnetic sub-core 14.2. The core structure or the four lateral core walls project preferably from the cover 15 and/or extend up to the PCB 5, in particular to the opening 5.1. Preferably, the core structure and/or the four lateral core walls are arranged around the opening 5.1 in the PCB 5. The core structure comprises preferably a distal wall opposed to the PCB 5. The distal wall is preferably parallel to the PCB plane and/or to the cover 15. Preferably, the distal wall is provided by the cover 15. The core structure comprises preferably an open side which faces the PCB 5, in particular its opening 5.1. The magnetic core 14, preferably the second magnetic sub-core 14.2 can be inserted from the open side of the core structure, before mounting the cover 15 on the PCB 5. The magnetic core 14, in particular the second magnetic sub-core 14.2 is preferably in contact with the distal wall. The core structure 12.1 of the housing 12, the opening 5.1 of the PCB 5 and the core structure of the cover 15 form thus a support for the magnetic core 14. Preferably, the magnetic core 14, in particular the second magnetic sub-core 14.1 extends between the first wall 8.1 of the busbar housing 8 and a first, second and third lateral core structure wall of the core structure 12.1, between the open side of the busbar housing 8 and two lateral core structure wall and the distal wall of the core structure of the cover 15, and/or between the third wall 8.3 of the busbar housing 8 and a fourth lateral core structure wall of the core structure 12.1 and the second and third lateral core structure wall of the core structure 12.1. The magnetic core 14, in particular the second magnetic sub-core 14.2 is preferably glued in the core structure of the cover 15, preferably to its distal wall.

The housing 12 comprises preferably fixation elements for fixing the housing 12 to the PCB 5 and/or to a cover 15. The fixation element could be a screw opening, preferably a threaded screw opening. The PCB 5 comprises preferably corresponding fixation elements for fixing the fixation elements of the PCB 5 to the fixation elements of the housing 12 and/or to fixation elements of the cover 15. The fixation element of the PCB 5 are preferably screw openings. The cover 15 comprises preferably corresponding fixation elements for fixing the fixation elements of the cover 15 to the fixation elements of the housing 12 and/or to the fixation elements of the PCB 5. The fixation element of the cover 15 are preferably screw openings. The screw opening of the housing 12, the PCB 5 and the cover 15 are fixed by a common screw. Alternative fixation elements could be snap-fit, press-fit, form-fit elements.

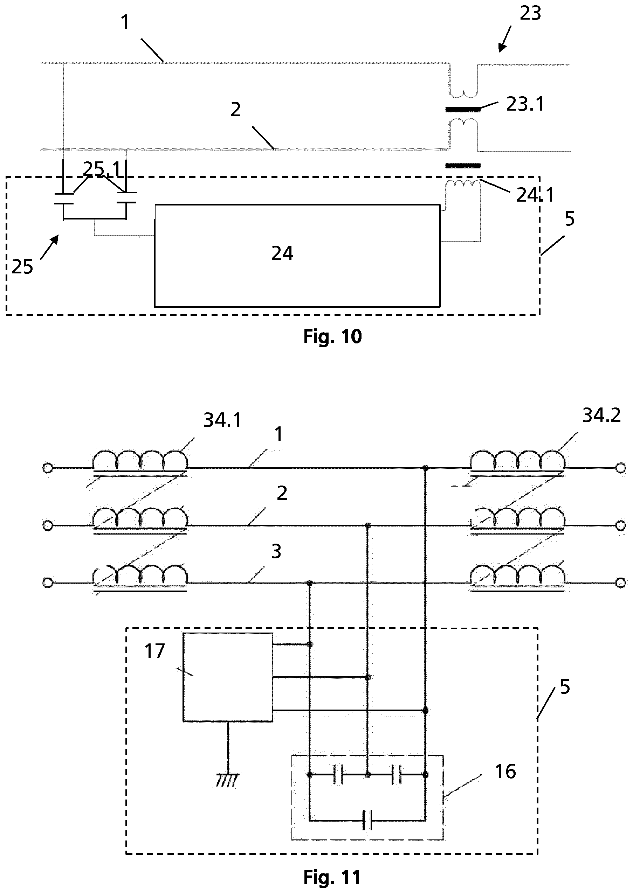

The circuit of the filter shown in Fig. 1 is just one embodiment of the filter. The filter shown is a passive filter. Many other circuits for passive filters are possible. The filter can also be realized as an active filter as shown in a second embodiment of the filter in Fig. 10. Just the electrical circuit of the active filter is shown. The mechanical realization of the active filter is analogous to the first embodiment shown in Fig. 2 to 9. The active filter comprises a noise sensing section 23 for sensing the noise in the first and second busbar 1, 2, a gain section 24 for generating a noise compensation based on the sensed noise and an injection section 25 for injecting the noise compensation in the first and/or second busbar 1, 2. Preferably the noise sensing section 24 is a current transformer (current compensated inductor) for sensing the noise current in the first and/or second busbar 1, 2. Preferably, the current compensated inductor is realized by a magnetic core 24.1 around the first and second busbar 1, 2, i.e. around the busbar assembly 6. The inductor or the magnetic core 24.1 is realized as described above for the at least one inductor 4.1, 4.2 or for the at least one magnetic core 14. The current sensor distinguishes from the current compensated choke described above by the auxiliary winding 24.1. The auxiliary winding can be realized by conductor tracks of the PCB 5, a wire or a combination of a wire and a conductor track. The wire would be a further electrical component to be mounted on the PCB 5. Preferably, the injection section is a capacitor 25.1 for injecting the noise compensation in the first and/or second busbar 1, 2. Preferably, the injection section comprises a first capacitor 25.1 for injecting the noise compensation into the first busbar 1 and a second capacitor 25.1 for injecting the noise compensation into the second busbar 2. The capacitors 25.1 of the injection section form electrical components mounted on the PCB 5 as described in the first embodiment. The capacitors 25.1 are connected by connectors 1.3, 2.3 to the busbar assembly 6 or to the first busbar 1 and the second busbar 2. The gain section 24, e.g. an amplifier, forms a further electrical component mounted on the PCB 5. The mechanical realization of the filter is analogous to the first embodiment, just with one inductor 24 and with different electrical components on the PCB 5.

The filter described above can be used in a network, preferably a DC-network with two main power conductors. The second terminals 1.2, 2.2 of the busbars 1, 2 are preferably connected with the noise source. Preferably, the filter is installed in a system with such a network. The system is preferably a vehicle with a DC-network, preferably an (in part or fully) electrically driven vehicle, like a hybrid or electric vehicle. The DC-network of the vehicle comprises preferably a battery and a converter. The converter is configured to convert an AC-current from a power network or from a motor generator into a DC current for charging the battery and/or is configured to convert a DC-current for driving the electrical motor of the car. The converter is considered as the noise source and is therefore connected with the second terminals 1.2, 2.2 of the busbars 1, 2. The first terminals 1.1, 2.1 are connected with the DC-network, in particular with the battery.

In the following, the method for manufacturing the filter is described.

In a first step, all parts of the filter necessary for the manufacturing are provided. All parts include for example, the busbar assembly 6, the PCB 5, the electrical components and preferably, the magnetic core(s) 14, the housing 12 and the cover 15. Preferably, the step of providing the busbar assembly 6 comprises the step of forming or manufacturing the busbar assembly 6. Preferably, the at least one first connector 1.3 is connected (with its proximal end) to the first busbar 1. Fig. 2 shows the busbar 1 with the connected at least one first connectors 1.3. If the at least one first connector 1.3 is integral to the first busbar 1, this step can be omitted. Preferably, the at least one second connector 2.3 is connected (with its proximal end) to the second busbar 2. If the at least one second connector 2.3 is integral to the second busbar 2, this step can be omitted. Then, the first busbar 1 is inserted and/or fixed and/or mounted in (the first recess of) the busbar housing 8, and the second busbar 2 is inserted and/or fixed and/or mounted in (the second recess) of the busbar housing 8. Then, the busbar assembly 6 is ready. The order of the steps for forming the busbar assembly 6 can be changed arbitrarily. However, it is preferred that the at least one first connector 1.3 is connected (with its proximal end) to the first busbar 1 before inserting the first busbar 1 into the busbar housing 8.It is further preferred that the at least one second connector 2.3 is connected (with its proximal end) to the second busbar 2 before inserting the second busbar 2 into the busbar housing 8. Fig. 3 shows the formed busbar assembly 6. Preferably, the busbar assembly 6 (and the electrical components) form one component which can be treated as a standard PCB component so that the busbar assembly 6 (and the electrical components) can be mounted subsequently in an industrial process. The busbar assembly 6 (and the electrical components) have connectors (or solder tags) for through-hole technology (THT). However, the connectors can also be for SMT.

In the next step, the busbar assembly 6 is positioned and/or fixed on the PCB 5 as shown in Fig. 4. In the shown embodiment, this step includes inserting the form-fit-elements 8.4 of the busbar assembly 6 in the corresponding counterpart-form-fit elements 5.4 of the PCB 5 or vice versa. This facilitates the correct positioning of the busbar assembly 6 on the PCB 5. The connectors 1.3 and 2.3 extend in this position through the corresponding through-holes of the PCB 5. Preferably, the busbar assembly 6 is further fixed to the PCB 5 by the fixation element 8.5 of the busbar assembly 6 and the corresponding fixation elements of the PCB 5, in particular by the screws 10 extending through the screw holes of the PCB 5 and the screw holes 8.5 of the busbar assembly 6. The positioning and/or fixation of the busbar assembly 6 can be made automatically by a robot, because the busbar assembly 6 has the features of a standard PCB component. This positioning and/or fixing of a standard PCB component on the PCB 5 is also called populating. Thus, the PCB 5 is populated with the busbar assembly 6.

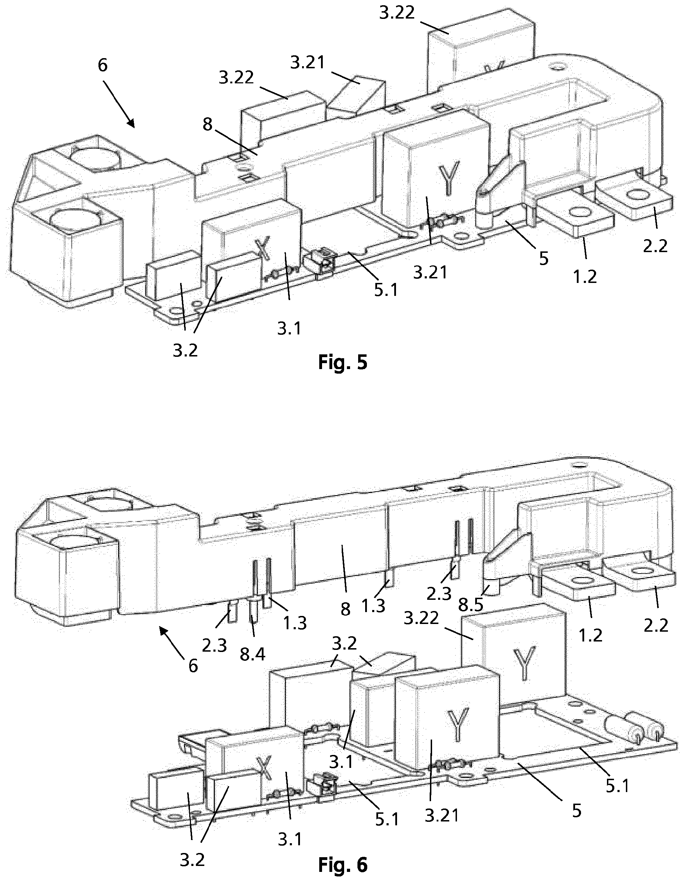

In the next step, the electrical components are positioned and/or fixed on the PCB 5 and/or the PCB 5 is populated with the electrical components. This includes in particular to insert the connectors, which are normally connector pins of the electrical components in the corresponding through-holes of the PCB 5. This is shown in Fig. 5.

Preferably, the PCB 5 is populated first with the busbar assembly 6 and then with the remaining electrical components as shown in Fig. 4 and 5. However, it is also possible to populate the PCB 5 first with the electrical components and then with the busbar assembly 6 as shown in Fig. 6. It is further possible to populate the PCB 5 first with at least one of the electrical components and then with the busbar assembly 6 and then with the remaining electrical components.

In a next step, the busbar assembly 6 and the electrical components are electrically connected, in particular soldered to the PCB 5. Preferably, a bulk soldering method like wave soldering or a selective soldering like selective wave soldering is used. Preferably, busbar assembly 6 and the electrical components are soldered in a common bulk soldering step. This is possible thanks to the realization of the busbar assembly 6 as a standard PCB component. The soldering step is performed by a soldering machine, preferably a bulk soldering machine, preferably a wave soldering machine. Thus, the filter can be manufactured in an industrial way, i.e. quick, reliable and automatized. However, in a less preferred embodiment, the busbar assembly 6 and the electrical components can be soldered to the PCB 5 in separate steps. The busbar assembly 6 can also be soldered before populating the PCB 5 with the electrical components or the electrical components can also be soldered before populating the PCB 5 with the busbar assembly 6.

After this step, the PCB assembly (PCBA), i.e. the PCB 5 with the electrical components and the busbar assembly 6 mounted on it, i.e. the PCB 5 with all standard PCB components soldered on it, is ready (if the at least one magnetic core 14 are considered to be part of the PCBA, except for the at least one magnetic core 14).

In a next step, the at least one magnetic core 14 is arranged around the busbars 1, 2, in particular around the busbar assembly 6 to form the at least one inductor 4.1, 4.2. Preferably, each magnetic core 14 is formed of at least two magnetic sub-cores comprising a first magnetic sub-core 14.1 and a second magnetic sub-core 14.2. Preferably, both sub-cores 14.1 and 14.2 are C-cores which together form a ring-formed magnetic core 14 around the busbar assembly 6.

In the following a preferred embodiment, for mounting the at least one magnetic core 14 together with the housing 12 and the cover 15 is described. Preferably, the at least one first sub-core is placed and/or fixed in the at least one core structure 12.1 of the housing 12. Preferably, the first sub-core 14.1 is glued in the core structure 12.1, preferably at its distal wall. However, the first sub-core 14.1 could alternatively or in addition be fixed by other measures in the housing 12 or in the core structure 12.1, e.g. by press-fit, snap-fit, screws, etc.. Then, the housing 12 is positioned on (the first side of) the PCB 5. Due to the first sub-core 14.1 which is positioned correctly in the housing 12 or in particular in the core structure 12.1, the housing 12 correctly positioned on the PCB 5 leads to the first sub-core 14.1 correctly positioned around the busbar assembly 6. This is shown in Fig. 7. Then, the at least one second sub-core 14.2 is placed (from the second side of the PCB 5) in the opening 5.1 of the PCB 5 (such to form together with the first sub-core 14.1 a ring-shaped core 14 around the busbar assembly 6. This is shown in Fig. 8. Then, then the cover 15 is placed on the second side of the PCB 5 and fixed to the PCB 5 and/or to the housing 12. The cover 15 presses the at least one second sub-core 14.2 into the at least one opening 5.1 and/or against the at least one first sub-core 14.1. Preferably, the cover 15 contained some glue (at the distal wall) in its at least one core structure such that the at least one second sub-core 14.2 is further glued in the cover 15. The at least one second sub-core 14.2 can be glued either first in the cover 15 before placing the cover 15 on the PCB 5, or the at least one second sub-core 14.2 can be placed before in the at least one opening 5.1 before placing the cover 15 on the PCB 5.
The filter according to the invention was described at the example of a two-busbar filter for a DC-network. However, the filter according to the invention can also be applied to a three-phase filter as shown for example in Fig. 3. Such a filter is preferably configured for a three-phase AC network. The busbar assembly 6 needs just a third busbar 3. The third busbar 3 is arranged preferably parallel to the first and second busbar 1, 2 as described in the first embodiment. The filter comprises preferably at least one, preferably two current compensated inductors 34.1, 34.2. The inductors 34 are preferably realized as in the first embodiment by forming a magnetic core 35 around the three busbars 1, 2, 3 or the busbar assembly 6 with the three busbars 1, 2, 3. The first inductor 34.1 defines preferably a first connection point between the first terminal and the first inductor 34.1 and a second connection point between the first inductor 34.1 and the second terminal. Preferably, the second inductor 34.2 defines the second connection point between the two inductors 34.1 and 34.2 and a third connection point between the second inductor 34.2 and the second terminals. The at least one capacitor comprise preferably (for one or more of the above-mentioned connection points) three X-capacitors 16 in star or delta connection between the three busbars 1, 2, 3 (at the respective connection point). The at least one capacitor comprise preferably (for one or more of the above-mentioned connection points) three Y-capacitors 17 between the three busbars 1, 2, 3 and ground, preferably the three Y-capacitors 17 are connected to a star point which is connected to ground. Such a three-phase AC filter could be connected to a three-phase AC network.

## Claims

1. Method for manufacturing a filter for electromagnetic noise comprising the following steps:
Forming a busbar assembly with a first busbar and a second busbar,
mounting on a printed circuit board the busbar assembly formed before, and
mounting at least one electrical component on the printed circuit board.

2. Method according to the previous claim, wherein the busbar assembly with the first busbar and the second busbar is formed as a single component, wherein the mounting of the busbar assembly on the printed circuit board comprises the step of soldering the single component to the printed circuit board.

3. Method according to one of the previous claims, wherein the busbar assembly comprises further a busbar housing for holding the first busbar and the second busbar.

4. Method according to the previous claim, wherein the busbar housing comprises a first wall, a second wall and a third wall, wherein the second wall is arranged between the first wall and the third wall, wherein the first busbar is arranged between the first wall and the second wall and the second busbar is arranged between the second wall and the third wall.

5. Method according to one of the last two previous claims, wherein the busbar housing comprises at least one form-fit-element and the printed circuit board comprises at least one counterpart-form-fit-element, wherein the for housing the at least one form-fit-element and the at least one counterpart-form-fit-element are formed such that the busbar assembly or the busbar housing can be positioned in (only) one mounting position on the printed circuit board by inserting the at least one form-fit-element in the at least one counterpart-form-fit-element or vice-versa.

6. Method according to one of the last three previous claims, wherein the busbar housing comprises at least one first snap-fit element for fixing the first busbar in a final position in the busbar housing and the busbar housing comprises at least one second snap-fit element for fixing the second busbar in a final position in the busbar housing.

7. Method according to one of the previous claims, wherein the busbar assembly comprises at least one first connector electrically connected to the first busbar and/or at least one second connector electrically connected to the second busbar, wherein the busbar assembly is mounted to the printed circuit board by electrically connecting the at least one first connector and/or the at least one second connector to conductor tracks of the printed circuit board.

8. Method according to the previous claim, wherein the step of forming the busbar assembly comprises the step of mounting the at least one first connector on the first busbar and/or mounting the at least one second connector on the second busbar.

9. Method according to one of the previous two claims, wherein the at least one first connector and/or the at least one second connector comprises a metal blade.

10. Method according to one of the previous four claims, wherein the at least one first connector and/or the at least one second connector comprises a distal end which provide the electrical interface of the busbar assembly to the printed circuit board, wherein the step of mounting the busbar assembly on the printed circuit board comprises the step of electrically connecting the distal end of at least one first connector and/or the distal end of the at least one second connector to the printed circuit board.

11. Method according to the previous claim, wherein the printed circuit board comprises at least one through hole connected with at least one of the conductor tracks of the printed circuit board, wherein the distal end of the at least one first connector and/or of the at least one second connector extends through the at least one through hole.

12. Method according to one of the previous six claims, wherein the at least one first connector and/or of the at least one second connector are soldered to the printed circuit board by a bulk soldering process.

13. Method according to one of the previous claims, wherein the at least one electrical component comprises at least one capacitor.

14. Method according to one of the previous claims comprising at least one inductor formed by a magnetic core around the first busbar and the second busbar.

15. Method according to the previous claim, wherein the magnetic core comprises at least two magnetic sub-cores, wherein one of the at least two magnetic sub-cores is part of the busbar assembly and is hold in the busbar assembly between the first busbar and the second busbar.

16. A filter for electromagnetic noise comprising:
a printed circuit board;
a busbar assembly with a first busbar and a second busbar; and
at least one electrical component mounted on the printed circuit board;
**characterized in that**
the busbar assembly forms a single component which is electrically connected to the printed circuit board.

17. A vehicle comprising an electrical DC voltage network and a filter as claimed in the previous claim connected to the electrical DC voltage network.
